(19) Europäisches Patentamt / European Patent Office / Office européen des brevets

(11) **EP 2 005 480 B1**

(12) **EUROPEAN PATENT SPECIFICATION**

(45) Date of publication and mention
of the grant of the patent:
**04.01.2017 Bulletin 2017/01**

(21) Application number: **06728174.1**

(22) Date of filing: **21.03.2006**

(51) Int Cl.:
*H01L 27/144* (2006.01)     *H01L 31/0224* (2006.01)
*H01L 31/0352* (2006.01)     *H01L 31/101* (2006.01)

(86) International application number:
**PCT/IL2006/000364**

(87) International publication number:
**WO 2007/107973 (27.09.2007 Gazette 2007/39)**

(54) **REDUCED DARK CURRENT PHOTODETECTOR**

FOTODETEKTOR MIT VERRINGERTEM DUNKELSTROM

PHOTODÉTECTEUR À COURANT D'OBSCURITÉ RÉDUIT

(84) Designated Contracting States:
**AT BE BG CH CY CZ DE DK EE ES FI FR GR HU
IE IS IT LI LT LU LV MC NL PL PT RO SE SI SK TR**

(43) Date of publication of application:
**24.12.2008 Bulletin 2008/52**

(73) Proprietor: **Maimon, Shimon**
**34608 Haifa (IL)**

(72) Inventor: **Maimon, Shimon**
**34608 Haifa (IL)**

(74) Representative: **Messulam, Alec Moses**
**Harrison IP**
**Westminster Business Centre**
**10 Great North Way**
**Nether Poppleton**
**York YO26 6RB (GB)**

(56) References cited:
**WO-A1-2005/004243      WO-A1-2005/004243
WO-A1-2005/057668      GB-A- 2 127 619
US-A- 4 731 640        US-A- 5 047 622
US-B1- 6 531 721       US-B1- 6 740 908**

• **CHEN ET AL. SEMICOND. SCI. TECHNOL. vol. 5,
1990, pages S100 - S102, XP020032140**

**Description**

BACKGROUND OF THE INVENTION

The invention relates generally to the field of semiconductor based photo-detectors and in particular to a photo-detector exhibiting a barrier region between an active semiconductor region and a contact semiconductor region.

Photo-detectors are used in a wide variety of applications including imaging. A specific type of photo-detector sensitive to the infra-red wavelengths of light is also known as an infra-red detector. Infra-red covers a broad range of wavelengths, and many materials are only sensitive to a certain range of wavelengths. As a result, the infra-red band is further divided into sub-bands such as near infra-red defined conventionally as 0.75 - 1.4 $\mu$m; short wavelength infra-red defined conventionally as 1.3 - 3 $\mu$m; mid wavelength infra-red defined conventionally as 3 - 8 $\mu$m; and far infra-red defined conventionally as 15 - 1,000 $\mu$m. Infra-red in the range of 5 $\mu$m to 8 $\mu$m is not well transmitted in the atmosphere and thus for many infra-red detection applications mid-wavelength infra-red is referred to as 3 - 5 $\mu$m.

Infra-red detectors are used in a wide variety of applications, and in particular in the military field where they are used as thermal detectors in night vision equipment, air borne systems, naval systems and missile systems. Highly accurate thermal detectors have been produced using InSb and HgCdTe p-n junction diodes, however these thermal detectors require cooling to cryogenic temperatures of around 77 K which is costly. The cryogenic temperatures primarily are used to reduce the dark current generated in the p-n junction diode by among other effects Shockley Reed Hall (SRH) generation.

There are three main contributions to the dark current, denoted as $I_{dark}$, of photodiodes based on narrow band gap semiconductors. The fluctuations of the dark current components are a major factor in the noise that limits the device performance. These components are:

   a) a generation current associated with the Shockley-Reed-Hall (SRH) process in the depletion region, $I_{srh}$;

   b) a diffusion current associated with auger or radiative processes in the extrinsic area, $I_{diff}$, and

   c) a surface current associated with the surface states in the junction, $I_{surf}$. The surface current depends primarily on the passivation process done for the device.

Thus, $I_{dark}$ can be expressed as:

$$I_{dark} = I_{srh} + I_{diff} + I_{surf}$$

Equation 1

The SRH generation process is very efficient in the depletion region of photodiodes where the mid-gap traps are highly activated. It is the main source of the dark current in photodiodes operable for mid-wavelength infrared at temperatures below 200K. The current associated with this source is:

$$J_{SRH} \approx q \frac{n_i}{\tau_{SRH}} W_{dep}$$

Equation 2

where $n_i$ is the intrinsic concentration of the semiconductor, $W_{dep}$ is the depletion width (typically in the range of 1 $\mu$m), and $\tau_{srh}$ is the SRH lifetime of minority carriers in the extrinsic area. The SRH lifetime of minority carriers in the extrinsic area depends on the quality of the material, i.e. the trap concentration, and is typically in the range of ~1$\mu$sec in low doped material (~$10^{16}$ cm$^{-3}$). The dependence of SRH current on $n_i$ produces an activation energy of Eg/2 ($n_i$~exp(-Eg/2/kT)), because the source of this generation process is through mid-gap traps. A secondary source of dark current in photodiodes is thermal generation in the neutral regions and diffusion to the other side of the junction. This thermal generation current depends on the auger or radiative process in this area, and is expressed as:

$$J_{diff} \approx q p_n \times \frac{1}{\tau_{diff}} \times L = q \frac{n_i^2}{N_d} \times \frac{1}{\tau_{diff}} \times L$$

Equation 3

where $\tau_{diff}$ is the lifetime, and in an n-type material exhibiting a doping concentration, denoted, $N_d$, of ~1-2.$10^{16}$ cm$^{-3}$ is

in the range of ~ 0.5µsec, depending only slightly on temperature. L is the width of the neutral region of the device or the diffusion length of minority carriers (the smaller of the two) and $p_n$ is the hole concentration in the active n type semiconductor in equilibrium and it equal to $n_i^2/N_d$. The activation energy of the diffusion current is Eg, ($n_i^2$ ~exp(-Eg/kT)) as the process involves band to band excitation.

Additionally, p-n junction diodes, and particularly those produced for thermal imaging require a passivation layer in the metallurgic junction between the p and n layers. Unfortunately this is often difficult to achieve and significantly adds to the cost of production.

There is thus a long felt need for a photo-detector having reduced dark noise. Preferably the photo-detector would be sensitive to the mid wavelength infrared band and not require expensive passivation in production. Further preferably the photo-detector would be operable at significantly higher temperatures than 77K.

UK Patent Application 2 127 619 relates to an infrared detector comprising an emitter region, a collector region, a pair of contacts, and a barrier region providing a barrier to the flow of majority carriers from the emitter region whilst being conductive for minority carriers.

US Patent 5,047,662 relates to an infrared radiation detector, having a first semiconductor layer deposited.on a substrate to form a diode junction with an overlay contact. The detector is rendered more effective by depositing a second semiconductor layer between the first layer and the overlay contact.

US Patent 6,740,908 relates to an enhanced extended drift heterostructure (EEDH) photodiode and a method of providing enhanced electron response.

## SUMMARY OF THE INVENTION

Accordingly, it is a principal object of the present invention to overcome the disadvantages of prior art photo-detectors, and in particular mid wavelength infra-red detectors. This is provided in the present invention by a photo-detector sensitive to a target waveband comprising a photo absorbing layer, preferably exhibiting a thickness on the order of the optical absorption length. In an exemplary embodiment the photo absorbing layer is deposited to a thickness of between one and two times the optical absorption length. A contact layer is further provided, and a barrier layer is interposed between the photo absorbing layer and the contact layer. The barrier layer exhibits a thickness sufficient to prevent tunneling of majority carriers from the photo absorbing layer to the contact layer, and a band gap barrier sufficient to block the flow of thermalized majority carriers from the photo absorbing layer to the contact layer. The barrier layer does not significantly block minority carriers.

An infra-red detector in accordance with the principle of the invention can be produced using either an n-doped photo absorbing layer or a p-doped photo absorbing layer, in which the barrier layer is designed to have no offset for minority carriers and a band gap barrier for majority carriers. Current in the detector is thus almost exclusively by minority carriers. In particular, for an n-doped photo absorbing layer the junction between the barrier layer and the absorbing layer is such that there is substantially zero valence band offset, i.e. the band gap difference appears almost exclusively in the conduction band offset. For a p-doped photo absorbing layer the junction between the barrier layer and the absorbing layer is such that there is substantially zero conduction band offset, i.e. the band gap difference appears almost exclusively in the valence band offset.

Advantageously the photo-detector of the subject invention does not exhibit a depletion layer, and thus the dark current is significantly reduced. Furthermore, in an exemplary embodiment passivation is not required as the barrier layer further functions to achieve passivation.

The invention provides for a photo-detector comprising: a photo absorbing layer comprising an n-doped semiconductor exhibiting a valence band energy level and a conducting band energy level; a barrier layer, a first side of the barrier layer adjacent a first side of the photo absorbing layer, the barrier layer exhibiting a valence band energy level substantially equal to the valence band energy level of the photo absorbing layer and a conduction band energy level exhibiting a significant band gap in relation to the conduction band of the photo absorbing layer; and a contact area comprising a doped semiconductor, the contact area being adjacent a second side of the barrier layer opposing the first side, the barrier layer exhibiting a thickness, the thickness and the band gap being sufficient to prevent tunnelling of majority carriers from the photo absorbing layer to the contact area and block the flow of thermalized majority carriers from the photo absorbing layer to the contact area.

In one embodiment the barrier layer comprises an undoped semiconductor. In another embodiment the contact area is n-doped. In a further embodiment, the contact area exhibits a valence band energy level substantially equal to the valence band energy level of the n-doped semiconductor of the photo absorbing layer.

In one embodiment the contact area is p-doped. In one further embodiment the contact area exhibits a valence band energy level greater than the valence band energy level of the n-doped semiconductor of the photo absorbing layer. In another further embodiment the barrier layer comprises an undoped semiconductor.

In one embodiment the photo absorbing layer is operable to generate minority carriers in the presence of light energy exhibiting a wavelength of 3 - 5 microns. In another embodiment the photo-detector further comprises a substrate exhibiting a first side adjacent a second side of the photo absorbing layer, the second side of the photo absorbing layer opposing the first side of the photo absorbing layer, the substrate exhibiting a second side in contact with a metal layer. Preferably, the photo-detector further comprises an additional metal layer in contact with the contact area.

In one embodiment the barrier layer comprises one of AlSb, AlAsSb, GaAlAsSb, AlPSb, AlGaPSb and HgZnTe. In a further embodiment the photo absorbing layer is constituted of one of n-doped InAs, n-doped InAsSb, n-doped InGaAs, n-doped Type II super lattice InAs/InGaSb and n-doped HgCdTe. In a yet further embodiment the contact area is constituted of one of InAs, InGaAs, InAsSb, Type II super lattice InAs/InGaSb, HgCdTe and GaSb. In a yet further embodiment the contact area and the photo absorbing layer exhibit substantially identical compositions.

In one embodiment the photo absorbing layer and the contact area are constituted of n-doped HgCdTe and the barrier layer is constituted of HgZnTe, and in another embodiment the photo absorbing layer and the contact layer are constituted of n-doped type II super lattice InAs/InGaSb and the barrier layer is constituted of AlGaAsSb. In another embodiment the photo absorbing layer is constituted of n-doped InAsSb, the barrier layer is constituted of AlGaAsSb and the contact layer is constituted of p-doped GaSb. In one embodiment the photo absorbing layer exhibits a thickness on the order of the optical absorption length.

The invention independently provides for a photo-detector comprising: a photo absorbing layer comprising a p-doped semiconductor exhibiting a conduction band energy level and a valence band energy level; a barrier layer, a first side of the barrier layer adjacent a first side of the photo absorbing layer, the barrier layer exhibiting a conduction band energy level substantially equal to the conduction band energy level of the photo absorbing layer and a valence band energy level exhibiting a significant band gap in relation to the valence band of the photo absorbing layer; and a contact area comprising a doped semiconductor, the contact area adjacent a second side of the barrier layer opposing the first side, the barrier layer exhibiting a thickness, the thickness and the band gap being sufficient to prevent tunneling of majority carriers from the photo absorbing layer to the contact area and to block the flow of thermalized majority carriers from the photo absorbing layer to the contact area.

In one embodiment the barrier layer comprises an undoped semiconductor. In another embodiment the contact area is p-doped. In one further embodiment the contact area exhibits a conduction band energy level substantially equal to the conduction band energy level of the p-doped semiconductor of the photo absorbing layer.

In one embodiment the contact area is n-doped. In one further embodiment the c ontact area exhibits a c onduction b and energy level less than the conduction band energy level of the p-doped semiconductor of the photo absorbing layer. In another further embodiment the barrier layer comprises an undoped semiconductor.

In one embodiment the photo absorbing layer is operable to generate minority carriers in the presence of light energy exhibiting a wavelength of 3 - 5 microns. In another embodiment the photo-detector further comprises a substrate exhibiting a first side adjacent a second side of the photo absorbing layer, the second side of the photo absorbing layer opposing the first side of the photo absorbing layer, the substrate exhibiting a second side in contact with a metal layer. In a further embodiment the photo-detector further comprises a metal layer in contact with the contact area.

In one embodiment the barrier layer comprises one of AlSb, AlAsSb, GaAlAsSb, AlPSb, AlGaPSb, InAlAs, InAlAsSb, and HgZnTe. In one further embodiment the photo absorbing layer is constituted of one of p-doped InAs, p-doped InAsSb, p-doped InGaAs, p-doped Type II super lattice InAs/InGaSb and p-doped HgCdTe. In one yet further embodiment the contact area is constituted of one of InAs, InGaAs, InAsSb, Type II super lattice InAs/InGaSb, HgCdTe and GaSb. In one yet further embodiment the contact area and the photo absorbing layer exhibit substantially identical compositions.

The invention independently provides for a method of producing a photo-detector, the method comprising: providing a substrate; depositing on the substrate a photo absorbing layer comprising a doped semiconductor exhibiting an energy level associated with non-conducting majority carriers; depositing on the deposited photo absorbing layer a barrier layer exhibiting a thickness, an energy level associated with minority carriers of the photo absorbing layer substantially equal to the energy level of the photo absorbing layer and a band gap associated with majority carriers of the photo absorbing layer; and depositing on the deposited barrier layer a contact layer comprising a doped semiconductor, the thickness and the band gap of the barrier layer being sufficient top revent tunneling of majority carriers from the photo absorbing layer to the contact layer and to block the flow of thermalized majority carriers from the photo absorbing layer to the contact layer.

In one embodiment the method further comprises selectively etching the deposited contact layer to define a plurality of contact areas. In another embodiment at least one of depositing the photo absorbing layer; depositing the barrier layer and depositing the contact layer is done via one of molecular beam epitaxy, m etal o rganic c hemical vapor d eposition, m etal organic phase epitaxy a nd liquid phase epitaxy.

Additional features and advantages of the invention will become apparent from the following drawings and description.

BRIEF DESCRIPTION OF THE DRAWINGS

For a better understanding of the invention and to show how the same may be carried into effect, reference will now be made, purely by way of example, to the accompanying drawings in which like numerals designate corresponding elements or sections throughout.

With specific reference now to the drawings in detail, it is stressed that the particulars shown are by way of example and for purposes of illustrative discussion of the preferred embodiments of the present invention only, and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice. In the accompanying drawings:

Fig. 1A illustrates a high level schematic view of the layers of a single photo-detector according to an embodiment of the principle of the invention;

Fig. 1B illustrates a side view of a multi-pixel photo-detector according to an embodiment of the principle of the invention;

Fig. 1C illustrates a top level view of the multi-pixel photo-detector of Fig. 1B according to a principle of the invention;

Fig. 2A illustrates the energy band levels of an embodiment of the structure of Fig. 1 according to the principle of the invention in which the photo absorbing layer is n-doped and the contact layer is n-doped;

Fig. 2B illustrates the energy band levels of an embodiment of the structure of Fig. 1 according to the principle of the invention in which the photo absorbing layer is p-doped and the contact layer is p-doped;

Fig. 3A illustrates the energy band levels of an embodiment of the structure of Fig. 1 according to the principle of the invention in which the photo absorbing layer is n-doped and the contact layer is p-doped;

Fig. 3B illustrates the energy band levels of an embodiment of the structure of Fig. 1 according to the principle of the invention in which the photo absorbing layer is p-doped and the contact layer is n-doped; and

Fig 4 illustrates a high level flow chart of the process of manufacture of the multi pixel photo-detector of Figs. 1B - 1C.

DETAILED DESCRIPTION OF THE PREFERRED EMBODIMENTS

The present embodiments enable a photo-detector sensitive to a target waveband comprising a photo absorbing layer, preferably exhibiting a thickness on the order of an optical absorption length of the target waveband. In an exemplary embodiment the photo absorbing layer is deposited to a thickness of between one and two times the optical absorption length. A contact layer is further provided, and a barrier layer is interposed between the photo absorbing layer and the contact layer. The barrier layer exhibits a thickness sufficient to prevent tunneling of majority carriers from the photo absorbing layer to the contact layer, and a band gap barrier sufficient to block the flow of thermalized majority carriers from the photo absorbing layer to the contact layer. The barrier layer does not significantly block minority carriers.

An infra-red detector in accordance with the principle of the invention can be produced using either an n-doped photo absorbing layer or a p-doped photo absorbing layer, in which the barrier layer is designed to have substantially no offset for minority carriers and a band gap barrier for majority carriers. Current in the detector is thus almost exclusively by minority carriers. In particular, for an n-doped photo absorbing layer the junction between the barrier layer and the absorbing layer is such that there is substantially zero valence band offset, i.e. the band gap difference appears almost exclusively in the conduction band offset. For a p-doped photo absorbing layer the junction between the barrier layer and the absorbing layer is such that there is substantially zero conduction band offset, i.e. the band gap difference appears almost exclusively in the valence band offset.

Advantageously the photo-detector of the subject invention does not exhibit a depletion layer, and thus the dark current is significantly reduced. Furthermore, in an exemplary embodiment passivation is not required as the barrier layer further functions to achieve passivation.

Before explaining at least one embodiment of the invention in detail, it is to be understood that the invention is not limited in its application to the details of construction and the arrangement of the components set forth in the following description or illustrated in the drawings. The invention is applicable to other embodiments or of being practiced or carried out in various ways. Also, it is to be understood that the phraseology and terminology employed herein is for the purpose of description and should not be regarded as limiting.

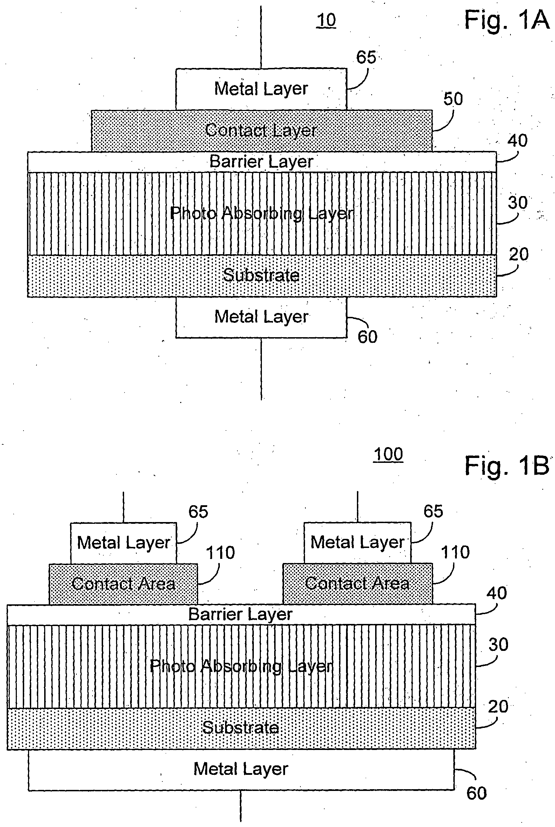

Fig. 1A illustrates a high level schematic view of the layers of a photo-detector 10 according to an embodiment of the principle of the invention comprising a substrate 20, a photo absorbing layer 30, a barrier layer 40, a contact layer 50, a metal layer 60 and a metal layer 65. Substrate 20 is provided as a base for deposition and has deposited on one face metal layer 60 for connection to electronic circuitry. In an exemplary embodiment metal layer 60 is constituted of gold. Photo absorbing layer 30 is deposited on the second face of substrate 20 opposing the first face. Photo absorbing layer 30 comprises a doped semiconductor responsive to photons of the object wavelength, and preferably is deposited to a thickness on the order of an optical absorption length. In one embodiment photo absorbing layer 30 is deposited to a thickness of between one and two times the optical absorption length. In an exemplary embodiment photo absorbing layer 30 comprises one of n-doped InAs; n-doped InAsSb; n-doped InGaAs; n-doped type II super lattice of the type InAs/InGaSb; and n-doped HgCdTe. In an alternative embodiment absorbing layer 30 comprises one of p-doped InAs; p-doped InAsSb; p-doped InGaAs; p-doped type II super lattice of the type InAs/InGaSb; and p-doped HgCdTe.

Barrier layer 40 is deposited directly on photo absorbing layer 30 without requiring passivation. Barrier layer 40 is deposited to a thickness sufficient to substantially prevent tunneling of majority carriers from photo absorbing layer 30 to contact layer 50, and in an exemplary embodiment is deposited to a thickness of 50 - 100 nm. Barrier layer 40 comprises a material selected to exhibit a high band gap barrier for majority carriers from photo absorbing layer 30 and substantially no band gap barrier for minority carriers. Barrier layer 40 is thus sufficient to block both the flow of thermalized majority carriers and the tunneling of majority carriers from photo absorbing layer 30 to contact layer 50. Thus, for an n-type photo absorbing layer 30, the band gap difference appears in the conduction band, whereas substantially no band gap offset appears in the valence band. In one embodiment barrier layer 40 comprises one of AlSb, AlAsSb, GaAlAsSb, AlPSb, AlGaPSb and HgZnTe. In an exemplary embodiment photo absorbing layer 30 comprises n-doped InAs and barrier layer 40 is comprised of $AlAs_xSb_{1-x}$ with x~0.15, and thus there is ~0 valence band offset.

Contact layer 50 is deposited on barrier layer 40. Contact layer 50 functions to absorb the minority carriers diffused from the absorbing layer 30 and is essentially a contact layer. In an exemplary embodiment contact layer 50 is deposited to a thickness of 20 - 50 nm and is constituted of one of InAs; InAsSb; InGaAs; type II super lattice of the type InAs/InGaSb; HgCdTe and GaSb. Contact layer 50 may be n-doped or p-doped without exceeding the scope of the invention. Advantageously, contact layer 50 may be constituted of the same material as photo absorbing layer 30. Contact layer 50 is etched, preferably by photolithography, to define the detector area. Advantageously etching of barrier layer 40 or absorbing layer 30 is not required. Metal layer 65 is deposited on contact layer 50, and in an exemplary embodiment is constituted of gold. Metal layers 60, 65 enable the connection of an appropriate bias, and a connection to detect a flow of current from photo absorbing layer 30 to contact layer 50.

Fig. 1B illustrates a side view of a multi-pixel photo-detector 100 according to an embodiment of the principle of the invention comprising substrate 20, photo absorbing layer 30, barrier layer 40, a first and second contact area 110, a metal layer 6 and a metal layer 65. Substrate 20 is provided as a base for deposition and has deposited on one face metal layer 60 for connection to electronic circuitry. In an exemplary embodiment metal layer 60 is constituted of gold. Photo absorbing layer 30 is deposited on the second face of substrate 20 opposing the first face: Photo absorbing layer 30 comprises a doped semiconductor responsive to photons of the object wavelength, and preferably is deposited to a thickness on the order of an optical absorption length. In one embodiment photo absorbing layer 30 is deposited to between one and two times the optical absorption length. In an exemplary embodiment photo absorbing layer 30 comprises one of n-doped InAs; n-doped InAsSb; n-doped InGaAs; n-doped type II super lattice of the type InAs/InGaSb; and n-doped HgCdTe. In an alternative embodiment absorbing layer 30 comprises one of p-doped InAs; p-doped InAsSb; p-doped InGaAs; p-doped type II super lattice of the type InAs/InGaSb; and p-doped HgCdTe.

Barrier layer 40 is deposited directly on photo absorbing layer 30 without requiring passivation. Barrier layer 40 is deposited to a thickness sufficient to substantially prevent tunneling of majority carriers from photo absorbing layer 30 to first and second contact area 110, and in an exemplary embodiment is deposited to a thickness of 50 - 100 nm. Barrier layer 40 comprises a material selected to exhibit a high band gap barrier for majority carriers from photo absorbing layer 30 and substantially no band gap barrier for minority carriers. Barrier layer 40 is thus sufficient to block both the flow of thermalized majority carriers and the tunneling of majority carriers from photo absorbing layer 30 to first and second contact area 110. Thus, for an n-type photo absorbing layer 30, the band gap difference appears in the conduction band, whereas substantially no band gap offset appears in the valence band. In one embodiment barrier layer 40 comprises one of AlSb, AlAsSb, GaAlAsSb, AlPSb, AlGaPSb and HgZnTe. In an exemplary embodiment photo absorbing layer 30 comprises n-doped InAs and barrier layer 40 is comprised of $AlAs_xSb_{1-x}$ with x~0.15, and thus there is ~0 valence band offset.

Contact layer 50 as described above in relation to Fig. 1A is deposited on barrier layer 40. Contact layer 50, which as will be described further is etched to define first and second contact area 110, functions to absorb the minority carriers diffused from the absorbing layer 30 and is essentially a contact layer. In an exemplary embodiment contact layer 50 is deposited to a thickness of 20 - 50 nm and is constituted of one of InAs; InAsSb; InGaAs; type II super lattice of the type InAs/InGaSb; HgCdTe and GaSb. Contact layer 50 may be n-doped or p-doped without exceeding the scope of the invention. Advantageously, contact layer 50 may be constituted of the same material as photo absorbing layer 30. Contact layer 50 is etched, preferably by photolithography, to define first and second contact area 110. Advantageously etching of barrier layer 40 or absorbing layer 30 is not required. In an exemplary embodiment a selective etchant is used which does not etch barrier layer 40. Metal layer 65 is deposited on each of first and second contact area 110, and in an exemplary embodiment is constituted of gold. Thus, a single photo absorbing layer and barrier layer is utilized, with each unetched portion of contact layer 50 defining a pixel or individual detector.

The above has been described in an embodiment in which two pixels, or detectors are defined, however this is not meant to be limiting in any way. A large array of photo-detectors produced as above is specifically included in the invention.

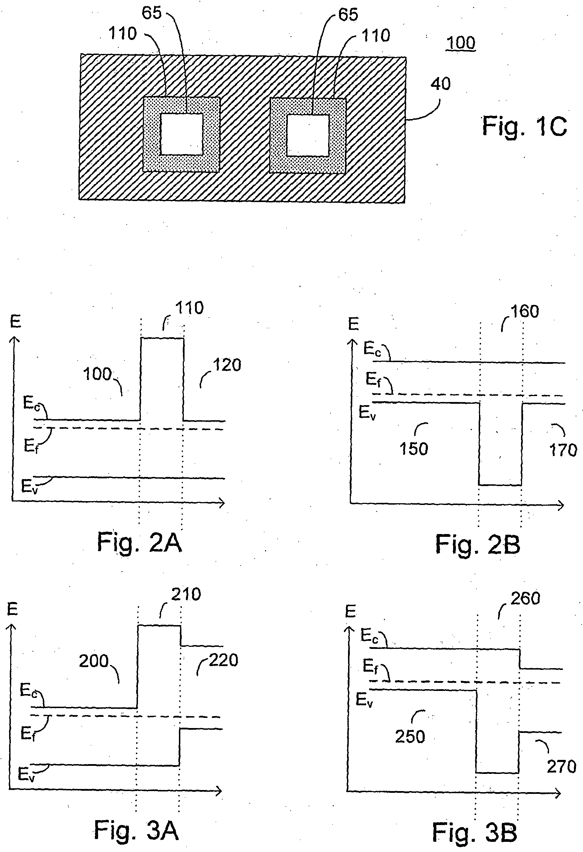

Fig. 1C illustrates a top level view of multi-pixel photo-detector 100 of Fig. 1B according to a principle of the invention showing barrier layer 40, first and second contact area 110 and metal layer 65 defined on each of first and second contact area 110.

Fig. 2A illustrates the energy band levels of an embodiment of the structure of Fig. 1 according to the principle of the invention in which the photo absorbing layer is n-doped and the contact layer is n-doped, in which the x-axis indicates position along the structure of Fig. 1 and the y-axis indicates energy levels in an arbitrary illustrative manner. Three energy band levels are depicted: $E_v$, the valence band energy band level; $E_f$, the Fermi energy band level; and $E_c$ the conducting band energy level. Area 100 represents the energy band levels within photo absorbing layer 30, area 110 represents the energy band levels within barrier layer 40 and area 120 represent the energy band levels within contact layer 50.

The valence band energy level is substantially constant throughout areas 100, 110 and 120, and thus minority carriers are not obstructed from flowing from photo absorbing area 100 to contact area 120. It is to be noted that due to the energy levels the minority carriers are captured in contact area 120. Barrier layer 40, represented by area 110, is thick enough so that there is negligible tunneling of majority carriers through it. In an exemplary embodiment barrier layer 40 is deposited to a thickness of 50 - 100 nm, and the band gap barrier of area 110 is high enough so that there is negligible thermal excitation of majority carriers over it. Area 120 shows energy band levels on a par with that of area 100 however this is not meant to be limiting in any way. In one embodiment $E_f$ in contact layer area 120 is slightly higher than their values in photo absorbing area 100 with the increase being attributed to an increased doping concentration. It is to be noted that no depletion layer is present and therefore there is no SRH current. Photocurrent is a result of optically generated minority carriers which diffuse from photo absorbing area 100 to contact area 120.

Fig. 2B illustrates the energy band levels of an embodiment of the structure of Fig. 1 according to the principle of the invention in which the photo absorbing layer is p-doped and the contact layer is p-doped; in which the x-axis indicates position along the structure of Fig. 1 and the y-axis indicates energy levels in an arbitrary illustrative manner. Three energy band levels are depicted: $E_v$, the valence band energy level; $E_f$, the Fermi energy band level; and $E_c$ the c onducting band energy level. Area 150 represents the energy band levels within photo absorbing layer 30, area 160 represents the energy band levels within barrier layer 40 and area 170 represent the energy band levels within contact layer 50.

The conduction band energy level is substantially constant throughout areas 150, 160 and 170, and thus minority carriers are not obstructed from flowing from photo absorbing area 150 to contact area 170. It is to be noted that due to the energy levels the minority carriers are captured in contact area 170. Barrier layer 40, represented by area 160, is thick enough so that there is negligible tunneling of majority carriers through it. In an exemplary embodiment barrier layer 40 is deposited to a thickness of 50 - 100 nm, and the band gap barrier of area 160 is high enough so that there is negligible thermal excitation of majority carriers over it. Area 170 shows energy band levels on a par with that of area 150 however this is not meant to be limiting in any way. In one embodiment $E_f$ in contact layer area 170 is slightly higher than their values in photo absorbing area 150 with the increase being attributed to an increased doping concentration. It is to be noted that no depletion layer is present and therefore there is no SRH current. Photocurrent is a result of optically generated minority carriers which diffuse from photo absorbing area 150 to contact area 170.

Fig. 3A illustrates the energy band levels of an embodiment of the structure of Fig. 1 according to the principle of the invention in which the photo absorbing layer is n-doped and the contact layer is p-doped; in which the x-axis indicates position along the structure of Fig. 1 and the y-axis indicates energy levels in an arbitrary illustrative manner. Three energy band levels are depicted: $E_v$, the valence band energy level; $E_f$, the Fermi energy band level; and $E_c$ the conducting band energy level. Area 200 represents the energy band levels within photo absorbing layer 30, area 210 represents the energy band levels within barrier layer 40 and area 220 represent the energy band levels within contact layer 50.

The valence band energy level is substantially constant throughout areas 200 and 210 and is higher in area 220, and thus minority carriers are not obstructed from flowing from photo absorbing area 200 to contact area 220. It is to be noted that due to the energy levels the minority carriers are captured in contact area 220. Barrier layer 40, represented by area 210, is thick enough so that there is negligible tunneling of majority carriers through it. In an exemplary embodiment barrier layer 40 is deposited to a thickness of 50 - 100 nm, and the band gap barrier of area 210 is high enough so that there is negligible thermal excitation of majority carriers over it. It is to be noted that no depletion layer is present and therefore there is no SRH current. Photocurrent is a result of optically generated minority carriers which diffuse from photo absorbing area 200 to contact area 220.

Fig. 3B illustrates the energy band levels of an embodiment of the structure of Fig. 1 according to the principle of the invention in which the photo absorbing layer is p-doped and the contact layer is n-doped; in which the x-axis indicates position along the structure of Fig. 1 and the y-axis indicates energy levels in an arbitrary illustrative manner.

Three energy band levels are depicted: $E_v$, the valence band energy level; $E_f$, the Fermi energy band level; and $E_c$ the conducting band energy level. Area 250 represents the energy band levels within photo absorbing layer 30, area 260 represents the energy band levels within barrier layer 40 and area 270 represent the energy band levels within contact layer 50.

The conduction band energy level is substantially constant throughout areas 250 and 260 and it is lower in area 270, and thus minority carriers are not obstructed from flowing from the photo absorbing area 250 to contact area 270. It is to be noted that due to the energy levels the minority carriers are captured in contact area 270. Barrier layer 40, represented by area 260, is thick enough so that there is negligible tunneling of majority carriers through it. In an exemplary embodiment barrier layer 40 is deposited to a thickness of 50 - 100 nm, and the band gap barrier of area 260 is high enough so that there is negligible thermal excitation of majority carriers over it. It is to be noted that no depletion layer is present and therefore there is no SRH current. Photocurrent is a result of optically generated minority carriers which diffuse from photo absorbing area 250 to contact area 270.

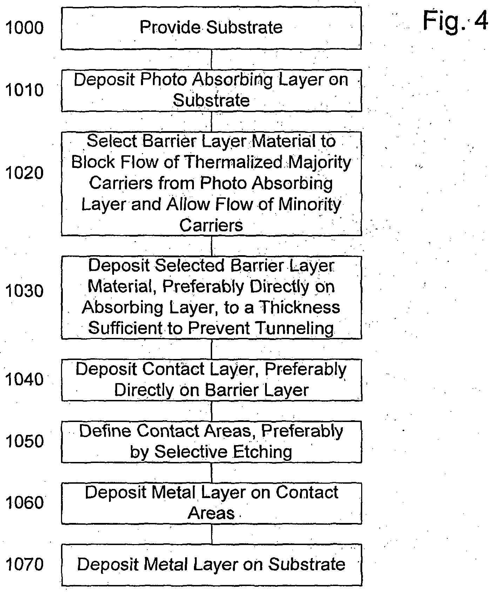

Fig 4 illustrates a high level flow chart of the process of manufacture of the photo-detector of Fig. 1. In stage 1000 a substrate material is provided as a support for d eposition. In s tage 1010, a photo absorbing layer is deposited on the substrate. Preferably the photo absorbing layer is deposited to a thickness on the order of the optical absorption length and in an exemplary embodiment is deposited to a thickness of between one and two times the optical absorption length.

In stage 1020, a barrier material is selected such that the flow of thermalized majority carriers from the photo absorbing layer deposited in stage 1010 would be negligible, and the flow of minority carriers is not impeded. In stage 1030, the barrier material selected in stage 1020 is deposited to a thickness sufficient to prevent tunneling of majority carriers through the barrier material. In an exemplary embodiment the thickness is between 50 and 100 nm. Preferably the barrier material is deposited directly on the photo absorbing layer deposited in stage 1010.

In stage 1040, a contact layer is deposited, preferably directly on the barrier material deposited in stage 1030. In stage 1050, the desired contact areas are defined. Preferably, the contact areas are defined by photolithography and a selective etchant which stops on the top of the barrier layer. Alternatively, the etchant may be controlled to stop once the uncovered portions of contact layer 50 are removed. Thus, the depth of the etch is equivalent to the thickness of the contact layer 50. Advantageously, in an exemplary embodiment no other layer is etched.

In stage 1060 a metal layer is deposited on the contact areas defined in stage 1050 so as to enable electrical connection. Preferably the metal layer is deposited directly on the contact areas defined in stage 1050. In stage 1070, a metal layer is deposited on substrate 20 provided in stage 1000 so as to enable electrical connection.

Deposition of the photo absorbing layer of stage 1010, the barrier layer of stage 1030 and the contact layer of stage 1040 may be accomplished by any means known to those skilled in the art including, without limitation molecular beam epitaxy, metal organic chemical vapor deposition, metal organic phase epitaxy or liquid phase epitaxy.

Thus the present embodiment enable a photo-detector sensitive to a target waveband comprising a photo absorbing layer, preferably exhibiting a thickness on the order of the optical absorption length. In an exemplary embodiment the photo absorbing layer is deposited to a thickness of between one and two times the optical absorption length. A contact layer is further provided, and a barrier layer is interposed between the photo absorbing layer and the contact layer. The barrier layer exhibits a thickness sufficient to prevent tunneling of majority carriers from the photo absorbing layer to the contact layer, and a band gap barrier sufficient to block the flow of thermalized majority carriers from the photo absorbing layer to the contact layer. The barrier layer does not block minority carriers.

An infra-red detector in accordance with the principle of the invention can be produced using either an n-doped photo absorbing layer or a p-doped photo absorbing layer, in which the barrier layer is designed to have no offset for minority carriers and a band gap barrier for majority carriers. Current in the detector is thus almost exclusively by minority carriers. In particular, for an n-doped photo absorbing layer the junction between the barrier layer and the absorbing layer is such that there is substantially zero valence band offset, i.e. the band gap difference appears almost exclusively in the conduction band offset. For a p-doped photo absorbing layer the junction between the barrier layer and the absorbing layer is such that there is substantially zero conduction band offset, i.e. the band gap difference appears almost exclusively in the valence band offset.

Advantageously the photo-detector of the subject invention does not exhibit a depletion layer, and thus the dark current is significantly reduced. Furthermore, in an exemplary embodiment passivation is not required as the barrier layer further functions to achieve passivation.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable sub-combination.

Unless otherwise defined, all technical and scientific terms used herein have the same meanings as are commonly understood by one of ordinary skill in the art to which this invention belongs. Although methods similar or equivalent to those described herein can be used in the practice or testing of the present invention, suitable methods are described herein.

All publications, patent applications, patents, and other references mentioned herein are incorporated by reference in their entirety. In case of conflict, the patent specification, including definitions, will prevail. In addition, the materials, methods, and examples are illustrative only and not intended to be limiting.

It will be appreciated by persons skilled in the art that the present invention is not limited to what has been particularly shown and described hereinabove. Rather the scope of the present invention is defined by the appended claims and includes both combinations and sub-combinations of the various features described hereinabove as well as variations and modifications thereof, which would occur to persons skilled in the art upon reading the foregoing description.

**Claims**

1. A photo-detector comprising:

   a photo absorbing layer (30), comprising an n-doped semiconductor exhibiting a valence band energy level and a conducting band energy level;
   a barrier layer (40), a first side of said barrier layer adjacent a first side of said photo absorbing layer, said barrier layer exhibiting a valence band energy level substantially equal to said valence band energy level of said photo absorbing layer and a conduction band energy level exhibiting a significant band gap in relation to the conduction band of said photo absorbing layer; and
   a contact area (110) comprising a doped semiconductor, said contact area being adjacent a second side of said barrier layer opposing said first side,
   said barrier layer exhibiting a thickness, said thickness and said band gap being sufficient to prevent tunneling of majority carriers from said photo absorbing layer to said contact area and to block the flow of thermalized majority carriers from said photo absorbing layer to said contact area,
   wherein the photo-detector is a multi-pixel photo-detector, and a contact layer is deposited on said barrier layer, where said contact layer is etched to define at least two contact areas,
   wherein each of said contact areas forms a mesa on said barrier layer such that said second side of said barrier layer extends laterally beyond said contact area, wherein said barrier layer is not etched so said barrier layer functions to achieve passivation of the photo-detector
   wherein a metal layer (65) is deposited on each of said contact areas.

2. A photo-detector according to claim 1, wherein said contact area is n-doped and exhibits a valence band energy level substantially equal to said valence band energy level of said n-doped semiconductor of said photo absorbing layer.

3. A photo-detector according to any of claims 1 or 2, wherein said contact area is p-doped and exhibits a valence band energy level greater than said valence band energy level of said n-doped semiconductor of said photo absorbing layer.

4. A photo-detector according to any of claims 1 or 2, wherein said barrier layer comprises an undoped semiconductor.

5. A photo-detector according to any of claims 1-4, wherein said photo absorbing layer is operable to generate carriers in the presence of light energy exhibiting a wavelength of 3 - 5 microns.

6. A photo-detector according to any of claims 1-5, further comprising a substrate exhibiting a first side adjacent a second side of said photo absorbing layer, said second side of said photo absorbing layer opposing said first said of said photo absorbing layer, said substrate exhibiting a second side in contact with a first metal layer.

7. A photo-detector according to claim 6, further comprising a second metal layer in contact with said contact area.

8. A photo-detector according to any of claims 1-7, wherein said photo absorbing layer exhibits a thickness on the order of the optical absorption length.

9. A photo-detector comprising:

   a photo absorbing layer (30), comprising an p-doped semiconductor exhibiting a conduction band energy level and a valence band energy level;

a barrier layer (40), a first side of said barrier layer adjacent a first side of said photo absorbing layer, said barrier layer exhibiting a conduction band energy level substantially equal to said conduction band energy level of said photo absorbing layer arid a valence band energy level exhibiting a significant band gap in relation to said valence band of said photo absorbing layer; and

a contact area (110) comprising a doped semiconductor, said contact area adjacent a second side of said barrier layer opposing said first side,

said barrier layer exhibiting a thickness, said thickness and said band gap being sufficient to prevent tunneling of majority carriers from said photo absorbing layer to said contact area and to block the flow of thermalized majority carriers from said photo absorbing layer to said contact area,

wherein the photo-detector is a multi-pixel photo-detector, and a contact layer is deposited on said barrier layer, where the contact layer is etched to define at least two contact areas,

wherein each of said contact areas forms a mesa on said barrier layer such that said second side of said barrier layer extends laterally beyond said contact area, wherein said barrier layer is not etched so said barrier layer functions to achieve passivation of the photo-detector

wherein a metal layer (65) is deposited on each of said contact areas.

10. A photo-detector according to claim 9, wherein said barrier layer comprises an undoped semiconductor.

11. A photo-detector according to any of claims 9-10, wherein said contact area is p-doped and exhibits a conduction band energy level substantially equal to said conduction band energy level of said p-doped semiconductor of said photo absorbing layer.

12. A photo-detector according to any of claims 9-10, wherein said contact area is n-doped and exhibits a conduction band energy level less than said conduction band energy level of said p- doped semiconductor of said photo absorbing layer.

13. A photo-detector according to any of claims 9-12, wherein said photo absorbing layer is operable to generate carriers in the presence of light energy exhibiting a wavelength of 3 - 5 microns.

14. A photo-detector according to any of claims 9-13, further comprising a substrate exhibiting a first side adjacent a second side of said photo absorbing layer, said second side of said photo absorbing layer opposing said first side of said photo absorbing layer, said substrate exhibiting a second side in contact with a metal layer.

15. A photo-detector according to claim 14, further comprising a metal layer in contact with said contact area.

**Patentansprüche**

1. Photodetektor, umfassend:

eine photoabsorbierende Schicht (30), umfassend einen n-dotierten Halbleiter, der ein Valenzband-Energieniveau und ein Leitband-Energieniveau aufweist;

eine Barriereschicht (40), wobei eine erste Seite der Barriereschicht an eine erste Seite der photoabsorbierenden Schicht angrenzt, wobei die Barriereschicht ein Valenzband-Energieniveau, das im Wesentlichen mit dem Valenzband-Energieniveau der photoabsorbierenden Schicht übereinstimmt, und ein Leitband-Energieniveau aufweist, das eine bedeutende Bandlücke in Bezug auf das Leitband der photoabsorbierenden Schicht aufweist; und

einen Kontaktbereich (110), umfassend einen dotierten Halbleiter, wobei der Kontaktbereich an eine zweite Seite der Barriereschicht angrenzt, die der ersten Seite gegenüberliegt, wobei die Barriereschicht eine Dicke aufweist, wobei die Dicke und die Bandlücke ausreichend sind, um ein Untertunneln von Majoritätsladungsträgern von der photoabsorbierenden Schicht zum Kontaktbereich zu verhindern und um den Strom von thermalisierten Majoritätsladungsträgern von der photoabsorbierenden Schicht zum Kontaktbereich zu blockieren,

wobei der Photodetektor ein Multipixel-Photodetektor ist und auf der Barriereschicht eine Kontaktschicht abgelagert ist, wobei die Kontaktschicht geätzt ist, um wenigstens zwei Kontaktbereiche zu definieren,

wobei jeder der Kontaktbereiche eine Mesa auf der Barriereschicht bildet, so dass sich die zweite Seite der Barriereschicht seitlich über den Kontaktbereich hinaus erstreckt, wobei die Barriereschicht nicht geätzt ist, so dass die Barriereschicht dazu dient, ein Passivieren des Photodetektors zu erreichen,

wobei auf jedem der Kontaktbereiche eine Metallschicht (65) abgelagert ist.

2. Photodetektor nach Anspruch 1, wobei der Kontaktbereich n-dotiert ist und ein Valenzband-Energieniveau aufweist, das im Wesentlichen mit dem Valenzband-Energieniveau des n-dotierten Halbleiters der photoabsorbierenden Schicht übereinstimmt.

3. Photodetektor nach einem der Ansprüche 1 oder 2, wobei der Kontaktbereich p-dotiert ist und ein Valenzband-Energieniveau aufweist, das größer als das Valenzband-Energieniveau des n-dotierten Halbleiters der photoabsorbierenden Schicht ist.

4. Photodetektor nach einem der Ansprüche 1 oder 2, wobei die Barriereschicht einen undotierten Halbleiter umfasst.

5. Photodetektor nach einem der Ansprüche 1-4, wobei die photoabsorbierende Schicht betreibbar ist, um in der Gegenwart von Lichtenergie, die eine Wellenlänge von 3 - 5 Mikrometer aufweist, Ladungsträger zu erzeugen.

6. Photodetektor nach einem der Ansprüche 1-5, weiter umfassend ein Substrat, das eine erste Seite aufweist, die an eine zweite Seite der photoabsorbierenden Schicht angrenzt, wobei die zweite Seite der photoabsorbierenden Schicht der ersten Seite der photoabsorbierenden Schicht gegenüberliegt, wobei das Substrat eine zweite Seite in Kontakt mit einer ersten Metallschicht aufweist.

7. Photodetektor nach Anspruch 6, weiter umfassend eine zweite Metallschicht in Kontakt mit dem Kontaktbereich.

8. Photodetektor nach einem der Ansprüche 1-7, wobei die photoabsorbierende Schicht eine Dicke in der Größenordnung der optischen Absorptionslänge aufweist.

9. Photodetektor, umfassend:

   eine photoabsorbierende Schicht (30), umfassend einen p-dotierten Halbleiter, der ein Leitband-Energieniveau und ein Valenzband-Energieniveau aufweist;
   eine Barriereschicht (40), wobei eine erste Seite der Barriereschicht an eine erste Seite der photoabsorbierenden Schicht angrenzt, wobei die Barriereschicht ein Leitband-Energieniveau, das im Wesentlichen mit dem Leitband-Energieniveau der photoabsorbierenden Schicht übereinstimmt, und ein Valenzband-Energieniveau aufweist, das eine bedeutende Bandlücke in Bezug auf das Valenzband der photoabsorbierenden Schicht aufweist; und
   einen Kontaktbereich (110), umfassend einen dotierten Halbleiter, wobei der Kontaktbereich an eine zweite Seite der Barriereschicht angrenzt, die der ersten Seite gegenüberliegt,

   wobei die Barriereschicht eine Dicke aufweist, wobei die Dicke und die Bandlücke ausreichend sind, um ein Untertunneln von Majoritätsladungsträgern von der photoabsorbierenden Schicht zum Kontaktbereich zu verhindern und um den Strom von thermalisierten Majoritätsladungsträgern von der photoabsorbierenden Schicht zum Kontaktbereich zu blockieren,
   wobei der Photodetektor ein Multipixel-Photodetektor ist und auf der Barriereschicht eine Kontaktschicht abgelagert ist, wobei die Kontaktschicht geätzt ist, um wenigstens zwei Kontaktbereiche zu definieren,
   wobei jeder der Kontaktbereiche eine Mesa auf der Barriereschicht bildet, so dass sich die zweite Seite der Barriereschicht seitlich über den Kontaktbereich hinaus erstreckt, wobei die Barriereschicht nicht geätzt ist, so dass die Barriereschicht dazu dient, ein Passivieren des Photodetektors zu erreichen,
   wobei auf jedem der Kontaktbereiche eine Metallschicht (65) abgelagert ist.

10. Photodetektor nach Anspruch 9, wobei die Barriereschicht einen undotierten Halbleiter umfasst.

11. Photodetektor nach einem der Ansprüche 9-10, wobei der Kontaktbereich p-dotiert ist und ein Leitband-Energieniveau aufweist, das im Wesentlichen mit dem Leitband-Energieniveau des p-dotierten Halbleiters der photoabsorbierenden Schicht übereinstimmt.

12. Photodetektor nach einem der Ansprüche 9-10, wobei der Kontaktbereich n-dotiert ist und ein Leitband-Energieniveau aufweist, das kleiner als das Leitband-Energieniveau des p-dotierten Halbleiters der photoabsorbierenden Schicht ist.

13. Photodetektor nach einem der Ansprüche 9-12, wobei die photoabsorbierende Schicht betreibbar ist, um in der Gegenwart von Lichtenergie, die eine Wellenlänge von 3 - 5 Mikrometer aufweist, Ladungsträger zu erzeugen.

**14.** Photodetektor nach einem der Ansprüche 9-13, weiter umfassend ein Substrat, das eine erste Seite aufweist, die an eine zweite Seite der photoabsorbierenden Schicht angrenzt, wobei die zweite Seite der photoabsorbierenden Schicht der ersten Seite der photoabsorbierenden Schicht gegenüberliegt, wobei das Substrat eine zweite Seite in Kontakt mit einer Metallschicht aufweist.

**15.** Photodetektor nach Anspruch 14, weiter umfassend eine Metallschicht in Kontakt mit dem Kontaktbereich.

**Revendications**

**1.** Photo-détecteur comprenant :

une couche photo-absorbante (30) comprenant un semi-conducteur dopé de type n présentant un niveau d'énergie de bande de valence et un niveau d'énergie de bande conductrice ;
une couche barrière (40), un premier côté de ladite couche barrière étant adjacent à un premier côté de ladite couche photo-absorbante, ladite couche barrière présentant un niveau d'énergie de bande de valence substantiellement égal audit niveau d'énergie de bande de valence de ladite couche photo-absorbante, et un niveau d'énergie de bande conductrice présentant une bande interdite significative relativement à la bande conductrice de ladite couche photo-absorbante ; et
une zone de contact (110) comprenant un semi-conducteur dopé, ladite zone de contact étant adjacente à un deuxième côté de ladite couche barrière opposée audit premier côté,

ladite couche barrière présentant une épaisseur, ladite épaisseur et ladite bande interdite étant suffisantes pour empêcher l'effet tunnel de porteurs de charge majoritaires de ladite couche photo-absorbante à ladite zone de contact et pour bloquer le flux de porteurs de charge majoritaires thermalisés de ladite couche photo-absorbante à ladite zone de contact,
le photo-détecteur étant un photo-détecteur multi-pixels, et une couche de contact étant déposée sur ladite couche barrière, ladite couche de contact étant gravée afin de définir au moins deux zones de contact,
chacune desdites zones de contact formant un mesa sur ladite couche barrière de sorte que ledit deuxième côté de ladite couche barrière s'étende latéralement au-delà de ladite couche de contact, ladite couche barrière n'étant pas gravée de sorte que ladite couche barrière fonctionne de façon à assurer la passivation du photo-détecteur une couche métallique (65) étant déposée sur chacune desdites zones de contact.

**2.** Photo-détecteur selon la revendication 1, ladite zone de contact étant dopée de type n, et présentant un niveau d'énergie de bande de valence substantiellement égal audit niveau d'énergie de bande de valence dudit semi-conducteur dopé de type n de ladite couche photo-absorbante.

**3.** Photo-détecteur selon une quelconque des revendications 1 ou 2, ladite zone de contact étant dopée de type p, et présentant un niveau d'énergie de bande de valence supérieur audit niveau d'énergie de bande de valence dudit semi-conducteur dopé de type n de ladite couche photo-absorbante.

**4.** Photo-détecteur selon une quelconque des revendications 1 ou 2, ladite couche barrière comprenant un semi-conducteur non dopé.

**5.** Photo-détecteur selon une quelconque des revendications 1 à 4, ladite couche photo-absorbante étant utilisable pour produire des porteurs en présence d'une énergie lumineuse présentant une longueur d'onde de 3 à 5 microns.

**6.** Photo-détecteur selon une quelconque des revendications 1 à 5, comprenant en outre un substrat présentant un premier côté adjacent à un deuxième côté de ladite couche photo-absorbante, ledit deuxième côté de ladite couche photo-absorbante étant opposé au premier côté de ladite couche photo-absorbante, ledit substrat présentant un deuxième côté en contact avec une première couche métallique.

**7.** Photo-détecteur selon la revendication 6, comprenant en outre une deuxième couche métallique en contact avec ladite zone de contact.

**8.** Photo-détecteur selon une quelconque des revendications 1 à 7, ladite couche photo-absorbante présentant une épaisseur de l'ordre de la longueur d'absorption optique.

**9.** Photo-détecteur comprenant :

une couche photo-absorbante (30) comprenant un semi-conducteur dopé de type p présentant un niveau d'énergie de bande conductrice et un niveau d'énergie de bande de valence ;
une couche barrière (40), un premier côté de ladite couche barrière adjacent à un premier côté de ladite couche photo-absorbante, ladite couche barrière présentant un niveau d'énergie de bande conductrice substantiellement égal audit niveau d'énergie de bande conductrice de ladite couche photo-absorbante et un niveau d'énergie de bande de valence présentant une bande interdite significative relativement à ladite bande de valence de ladite couche photo-absorbante ; et
une zone de contact (110) comprenant un semi-conducteur dopé, ladite zone de contact adjacente à un deuxième côté de ladite couche barrière étant opposé audit premier côté,

ladite couche barrière présentant une épaisseur, ladite épaisseur et ladite bande interdite étant suffisantes pour empêcher l'effet tunnel de porteurs de charge majoritaires de ladite couche photo-absorbante à ladite zone de contact et pour bloquer le flux de porteurs de charge majoritaires thermalisés de ladite couche photo-absorbante à ladite zone de contact,
le photo-détecteur étant un photo-détecteur multi-pixels, et une couche de contact étant déposée sur ladite couche barrière, ladite couche de contact étant gravée afin de définir au moins deux zones de contact,
chacune desdites zones de contact formant un mesa sur ladite couche barrière de sorte que ledit deuxième côté de ladite couche barrière s'étende latéralement au-delà de ladite couche de contact, ladite couche barrière n'étant pas gravée de sorte que ladite couche barrière fonctionne de façon à assurer la passivation du photo-détecteur une couche métallique (65) étant déposée sur chacune desdites zones de contact.

**10.** Photo-détecteur selon la revendication 9, ladite couche barrière comprenant un semi-conducteur non dopé.

**11.** Photo-détecteur selon une quelconque des revendications 9-10, ladite zone de contact étant dopée de type p, et présentant un niveau d'énergie de bande conductrice substantiellement égal audit niveau d'énergie de bande conductrice dudit semi-conducteur de type p de ladite couche photo-absorbante.

**12.** Photo-détecteur selon une quelconque des revendications 9-10, ladite zone de contact étant dopée de type n, et présentant un niveau d'énergie de bande conductrice inférieur audit niveau d'énergie de bande conductrice dudit semi-conducteur de type p de ladite couche photo-absorbante.

**13.** Photo-détecteur selon une quelconque des revendications 9-12, ladite couche photo-absorbante est utilisable pour produire des porteurs en présence d'une énergie lumineuse présentant une longueur d'onde de 3 à 5 microns.

**14.** Photo-détecteur selon une quelconque des revendications 9-13, comprenant en outre un substrat présentant un premier côté adjacent à un deuxième côté de ladite couche photo-absorbante, ledit deuxième côté de ladite couche photo-absorbante étant opposé au premier côté de ladite couche photo-absorbante, ledit substrat présentant un deuxième côté en contact avec une couche métallique.

**15.** Photo-détecteur selon la revendication 14, comprenant en outre une couche métallique en contact avec ladite zone de contact.

Fig. 1A

<u>10</u>

65

Metal Layer

50

Contact Layer

40

Barrier Layer

30

Photo Absorbing Layer

20

Substrate

Metal Layer

60

Fig. 1B

<u>100</u>

65

Metal Layer

110

Contact Area

65

Metal Layer

110

Contact Area

40

Barrier Layer

30

Photo Absorbing Layer

20

Substrate

Metal Layer

60

Fig. 1C

Fig. 2A

Fig. 2B

Fig. 3A

Fig. 3B

| 1000 | Provide Substrate |
|---|---|

Fig. 4

| 1010 | Deposit Photo Absorbing Layer on Substrate |
|---|---|

| 1020 | Select Barrier Layer Material to Block Flow of Thermalized Majority Carriers from Photo Absorbing Layer and Allow Flow of Minority Carriers |
|---|---|

| 1030 | Deposit Selected Barrier Layer Material, Preferably Directly on Absorbing Layer, to a Thickness Sufficient to Prevent Tunneling |
|---|---|

| 1040 | Deposit Contact Layer, Preferably Directly on Barrier Layer |
|---|---|

| 1050 | Define Contact Areas, Preferably by Selective Etching |
|---|---|

| 1060 | Deposit Metal Layer on Contact Areas |
|---|---|

| 1070 | Deposit Metal Layer on Substrate |
|---|---|

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2127619 A
- US 5047662 A
- US 6740908 B